## Europäisches Patentamt

(19) **European Patent Office**

**Office européen des brevets**

(11) Publication number: **0 069 233**
**A2**

(12) # EUROPEAN PATENT APPLICATION

(21) Application number: **82104897.2**

(22) Date of filing: **04.06.82**

(51) Int. Cl.³: **H 01 L 29/60**
**G 11 C 11/34**

(30) Priority: **29.06.81 US 278303**

(43) Date of publication of application:
**12.01.83 Bulletin 83/2**

(84) Designated Contracting States:
**DE FR GB**

(71) Applicant: **International Business Machines Corporation**

**Armonk, N.Y. 10504(US)**

(72) Inventor: **Fortino, Andres Guillermo**
**860 Goshen Road**
**New Town Square Pennsylvania(US)**

(72) Inventor: **Geipel, Henry John, Jr.**
**1 Alderbrook Road**
**Essex Junction Vermont(US)**

(72) Inventor: **Hsieh, Ning NMN**
**1573 Larkin Avenue**
**San Jose California(US)**

(74) Representative: **Rudolph, Wolfgang**
**Schönaicher Strasse 220**
**D-7030 Böblingen(DE)**

(54) **Memory array and methods of making same.**

(57) A memory array and a method of making same are provided, particularly for electrically alterable read only memories. The array includes a plurality of cells each of which has a floating gate and an enhanced conduction insulator segment (22, 24, 26, 28) or charge injector disposed between its associated floating gate (16-19) and a conductive line (58) common to the plurality of cells. The array is fabricated by appropriately forming the plurality of spaced apart floating gates insulated from a semiconductor substrate (10) and then forming an insulating layer (52) made of stoichiometric material over the plurality of floating gates and over the exposed surfaces located between the floating gates. By using masking techniques, opening (72) are formed in a mask (70) over the insulating layer (20) and aligned within the edges of each of the floating gates through which ions, preferably silicon ions, are introduced into the insulating layer to form desired silicon-rich regions in the insulating layer providing the enhanced conduction insulators or structures for each floating gate. A common conductive (58) line, which may act as a word line, is then formed over the stoichiometric insulating layer in contact with each of the enhanced conduction insulators (22, 24, 26, 28) or structures. Appropriate source and drain regions are provided in the semiconductor substrate (10) in association with each of the floating gates to which terminals are connected for selectively controlling, along with the common conductive or word line, the charge on the floating gates and the current flow between the source and drain regions.

./...

FIG. 3

## MEMORY ARRAY AND METHODS OF MAKING SAME

This invention relates to an integrated semiconductor storage system or transistor array having localized charge injectors which may be used, e.g., in electrically alterable read only memories (EAROM), in nonvolatile random access memories, or in electrically alterable programmable logic arrays and methods of making same.

Integrated semiconductor circuits, particularly systems or arrays having transistors each of which represents a binary digit of information, as in read only memories (ROM), have achieved high device or cell densities.

In, e.g., U. S. Patent 3 914 855, filed May 9, 1974, there is described a read only memory wherein the array has transistors made with a thin gate dielectric exhibiting a low threshold voltage for storing a 1 digit of binary information and transistors made of a thick gate dielectric exhibiting a considerably higher threshold voltage for storing the other digit of binary information.

In U. S. Patent 4 161 039, filed February 6, 1978, there is disclosed a memory array utilizing field effect transistors (FET) where information is stored in floating gates. This memory is not a simple read only memory but one that can be reprogrammed after erasing the stored information with ultraviolet light.

Commonly assigned U. S. Patent 3 972 059, filed December 28, 1973 by T. H. DiStefano discloses a charge store FET memory suitable for operation in a read only mode which includes a floating gate and a write gate separated by a first insulating layer having a low band gap at the write gate and an erase gate separated from the floating gate by a second insulating layer having a low band gap at the floating gate. The Di-Stefano patent teaches that the insulation layers having the low band gap may be fabricated by several procedures, including implantation of ions into the insulating layers.

Commonly assigned U. S. Patent 4 104 675, filed June 21, 1977, by D. J. DiMaria, et al discloses a non-destructive, long-term storage system using a single graded energy band gap or enhanced conduction insulator in which each cell may be driven by a low voltage. The DiMaria et al patent teaches that the graded structure may be fabricated by forming several pyrolytic or chemically vapor deposited (CVD) silicon dioxide layers over a relatively thick thermal silicon dioxide layer, with the pyrolytic silicon dioxide layers having sequentially increasing excess silicon content, and alternatively, this structure may be fabricated by controlled silicon implantation in the thermal silicon dioxide layer.

In commonly assigned U. S. Patent Application Serial No. 124 003, filed February 25, 1980, by D. J. DiMaria, there is disclosed a non-destructive, long-term storage system using a dual charge injector or dual graded energy band gap structure disposed in each cell which is driven by a low voltage.

In commonly assigned U. S. patent application Serial No. 153 359, filed May 27, 1980, by H. N. Kotecha, there is disclosed an improved system for charging and discharging, or writing and erasing, a conductive plate

BU 980 021

with a charge injector controlled by a low single polarity voltage. In a preferred embodiment of the invention, the conductive plate is a floating gate of a field effect transistor which also includes first and second or dual control gates. A single or double graded band gap layer, such as a silicon rich layer of silicon dioxide, is disposed only between the floating gate and the first control gate forming a capacitor having a given capacitance with a larger capacitor disposed between the second control gate and the floating gate. These cells store for long periods of time binary digits of information representing a 0 or a 1 depending upon whether a charge is stored on the floating gate.

Commonly assigned U. S. Patent application Serial No. 160 530, filed June 18, 1980, by H. N. Kotecha and F. W. Wiedman, discloses a memory system having cells each of which also has a charge injector but which includes only three terminals for writing, reading and erasing the cell.

A detailed discussion of enhanced conduction insulators may be found in an article entitled "High Current Injection Into $SiO_2$ from Si rich $SiO_2$ Films and Experimental Applications" by D. J. DiMaria and D. W. Dong, Journal of Applied Physics 51(5), May 1980, pp. 2722-2735, and a basic memory cell which utilizes the dual electron injector structure is taught in an article entitled "Electrically-Alterable Memory Using a Dual Electron Injector Structure", by D. J. DiMaria, K. M. DeMeyer and D. W. Dong, IEEE Electron Device Letters, Vol. EDL-1, No. 9, September 1980, pp. 179-181.

U. S. Patent 3 649 884, filed June 2, 1970, discloses forming an oxide layer with an excess of silicon through a reaction at $900^{\circ}$C of silane ($SiH_4$) and water vapor ($H_2O$) in the volume ratio $H_2O/SiH_4$ less than 10.

When employing ion implantation techniques, U. S. Patent 3 607 449, filed September 23, 1969, teaches the relationship between the penetration distance of ions into a layer of silicon dioxide and the ion beam energy, along with the use of a mask to selectively implant the ions into the silicon dioxide layer.

The technique for providing self-aligned doping regions by ion implant and lift-off and then depositing a layer of polysilicon over the doped region through the same opening is taught in IBM Patent 4 144 101, filed June 5, 1978, by V. L. Rideout. Also, in IBM Technical Disclosure Bulletin, Vol. 22, No. 3, August 1979, pp. 1237-1239, V. L. Rideout and V. J. Silvestri disclose implanting ions through an opening in a photoresist layer and then depositing aluminum through the same opening.

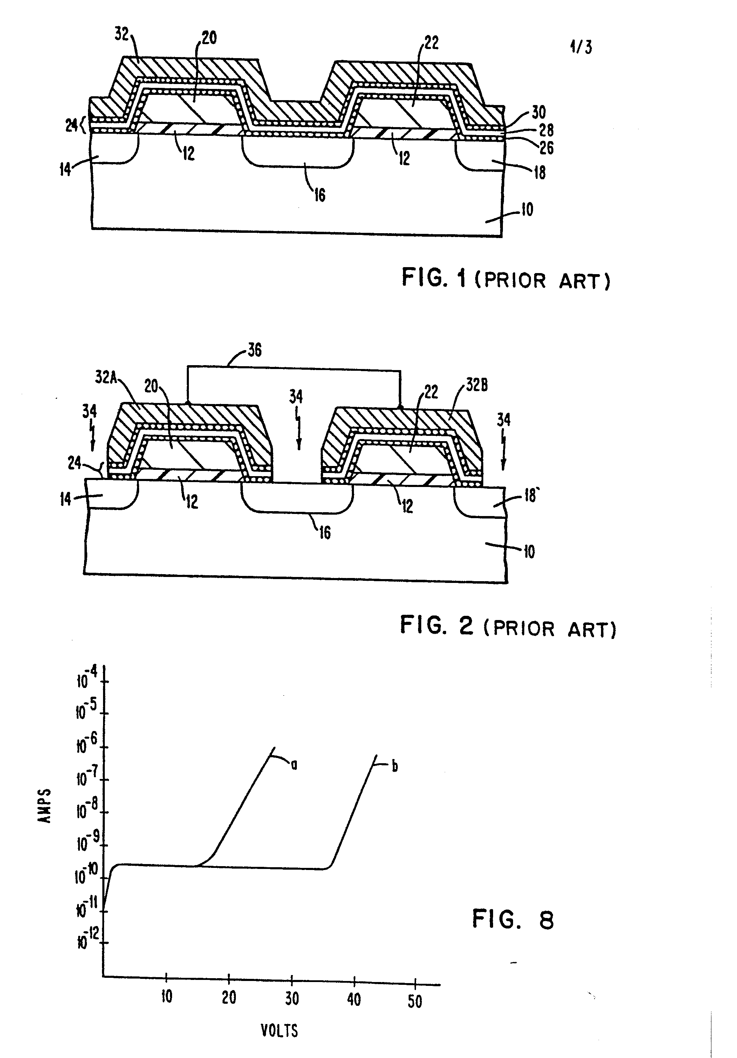

Many of the prior art techniques used for forming a graded energy band gap structure or enhanced conduction insulator provide a memory cell which operates satisfactorily, but problems arise when the prior art techniques are employed to form a memory array. Some of these problems include substantial charge leakage between adjacent cells of an array, lack of precise composition control, improper etching and passivation and lack of tailoring of the structure and properties. A prior art array structure and a prior art attempt to improve the array structure will be described in conjunction with Figs. 1 and 2 of the drawings.

BU 980 021

It is an object of this invention to provide at a low cost an improved very dense memory array having enhanced conduction insulators or graded energy band gap structures with very low cell to cell charge leakage, particularly having oxidizable graded energy band gap structures, made with minimum process perturbations having localized graded energy band gap structures, wherein electrical properties are readily fine tailored.

It is a further object of this invention to provide an improved electrically alterable read only memory array having graded energy band gap structures made by ion implantation techniques which are localized and oxidizable, and wherein other circuits, e.g., charge coupled or peripheral circuits, may be formed simultaneously on the same semiconductor chip.

Yet another object of the invention is to provide an improved method of making a memory array having localized graded energy band gap structures or enhanced conduction insulators which uses ion implantation techniques and of making a memory array having localized enhanced conduction insulators which uses lift-off and ion implantation techniques.

The objects are achieved by an integrated semiconductor storage system and a method of making same as defined in the characterizing part of claim 1 and 13 respectively.

Further improvements are characterized in claims 2-12 and 14-18.

In accordance with the teachings of this invention, an improved memory array and method of making same are provided, particularly. for electrically alterable read only memories. The array includes a plurality of cells each of which has a floating gate and an enhanced conduction insulator segment disposed between its associated floating gate and a conductive line common to the plurality of cells. The array is fabricated by appropriately forming the plurality of spaced apart floating gates insulated from a semiconductor substrate and then forming an insulating layer made of stoichiometric material over the plurality of floating gates and over the exposed surfaces located between the floating gates. By using masking techniques, openings are formed in a mask over the insulating layer and aligned within the edges of each of the floating gates through which ions, preferably silicon ions, are introduced into the insulating layer to form desired silicon rich regions in the insulating layer to provide enhanced conduction insulators or structures for each floating gate. A common conductive line is then formed over the stoichiometric insulating layer in contact with each of the enhanced conduction insulators or structures. Appropriate source and drain regions are provided in the semiconductor substrate in association with each of the floating gates to which terminals are connected for selectively controlling, along with the common conductive line, the charge on the floating gates and the current flow between the source and drain regions.

The foregoing and other objects, features and advantages of the invention will be apparent from the following and more particular description of the preferred embodiments of the invention, as illustrated in the accompanying drawings.

Fig. 1     is a cross-sectional view of two cells of a memory array, each having an enhanced conduction insulator or structure, as is known in the prior art;

Fig. 2     is a cross-sectional view of two cells of another memory array, each having an enhanced conduction insulator or structure, as is also known in the prior art;

Fig. 3     is a memory system including a plan view of a memory array of the present invention;

Fig. 4     is a cross-sectional view of the memory array illustrated in Fig. 3 of the drawings taken through line 4-4;

Fig. 5     is a cross-sectional view of the memory array illustrated in Fig. 3 of the drawings taken through line 5-5;

Fig. 6     is a cross-sectional view similar to that of Fig. 5 but illustrating an intermediate step in the method of making a memory array of the present invention;

Fig. 7     is a graph indicating the concentration of silicon as a function of depth into an insulating layer when introduced by ion implantation techniques;

BU 980 021

Fig. 8    shows I-V curves indicating the current flow through a layer of stoichiometric silicon dioxide and through an enhanced conduction insulating layer as a function of voltage; and

Figs. 9,    are cross-sectional views of a cell of the 10 and 11 memory array of the present invention shown at different steps during the making of the array.

Referring first to the prior art structure illustrated in Fig. 1 of the drawing in more detail, there is shown in cross-sectional view two cells of a memory array. The structure includes a semiconductor substrate 10, preferably made of silicon, with a silicon dioxide layer 12 grown on the surface of the substrate 10. Source and drain regions 14, 16 and 18 are provided at the upper surface of the of the semiconductor substrate 10 preferably after floating gates 20 and 22, made of doped polysilicon, are formed on the silicon dioxide layer 12. The graded energy band gap structure or enhanced conduction insulating layer 24 is then formed over the entire structure including the upper and side surfaces of the floating gates 20 and 22 and on the exposed surfaces between the floating gates 20 and 22. The enhanced conduction insulating layer 24 includes a first silicon-rich region 26 located at the lower portion of the enhanced conduction insulating layer 24 with a stoichiometric silicon dioxide region 28 located in the central portion of the enhanced conduction insulating layer 24 and a second silicon-rich region 30 located at the upper portion of the enhanced conduction insulating layer 24. A conductive line 32 which may be made from a second layer of doped polysilicon or aluminum is then formed over the enhanced conduction insulating layer 24. As is known, the floating gates 20 and 22 may be selectively charged or discharged to represent binary digits of information.

The enhanced conduction insulating layer 24 is generally made by growing or depositing a layer of stoichiometric silicon dioxide and distorting or modifying a portion of the layer with the introduction of additional silicon by well-known pyrolytic chemical vapor deposition techniques, by plasma enhanced chemical vapor depositon techniques, by low pressure chemical vapor deposition techniques, or alternatively, by ion implantation over the entire structure.

Although memory arrays having the structure illustrated in Fig. 1 of the drawings are relatively simple to fabricate, a problem has been found which is caused by high charge leakage between the cells, i.e., between the floating gates 20 and 22, due to the presence of the silicon-rich silicon dioxide extending between adjacent cells.

In order to alleviate the problem encountered in the structure indicated in Fig. 1, the structure has been modified, as illustrated in Fig. 2, by forming openings 34 in the enhanced conduction insulating layer 24 and in the conductive line 32. The openings 34 in the enhanced conduction insulating layer 24 eliminate the leakage problem, however, they introduce a new problem, in that the conductive line 32, which is generally required to be a continuous line, has now been severed into segments 32A and 32B. In order to provide elec-

BU 980 021

trical continuity from segment to segment, the segments 32A and 32B must be stitched by the use of an appropriate conductive line 36.

When the prior art structure illustrated in Fig. 2 is used, the size of the cells must be made larger because an allowance must be made for misalignment of the mask creating the openings 34. Additionally, each of the cells must provide a large area on the conductive line segments 32A and 32B for appropriate contacts to the conductive or stiching line 36. The misalignment problem encountered in the structure of Fig. 2 of the drawing can cause a reduction in the signal, since when etching the enhanced conduction insulating layer 24 the etchants known today cannot distinguish between silicon-rich silicon dioxide and stoichiometric or conventional silicon dioxide. Furthermore, the silicon-rich regions on the sides of the floating gates 20 and 22 in Figs. 1 and 2 produce an increase in capacitance between the floating gates 20 and 22 and the conductive line 32 or segments 32A and 32B which is detrimental to the operation of a memory array of the electrically alterable read only memory type, since it is generally desired that the capacitance between the floating gate and the conductive line 32 be maintained at a minimum value. Furthermore, when using the methods or structures of Figs. 1 and 2 of the drawings, wherein the silicon-rich layer is deposited over the entire structure, the conductive line 32, e.g. a second layer of polysilicon, cannot be used for peripheral devices on the same chip, since the insulator is now inappropriate for use as a gate dielectric in peripheral transistors.

In accordance with the teachings of the present invention, as illustrated in an embodiment shown in

BU 980 021

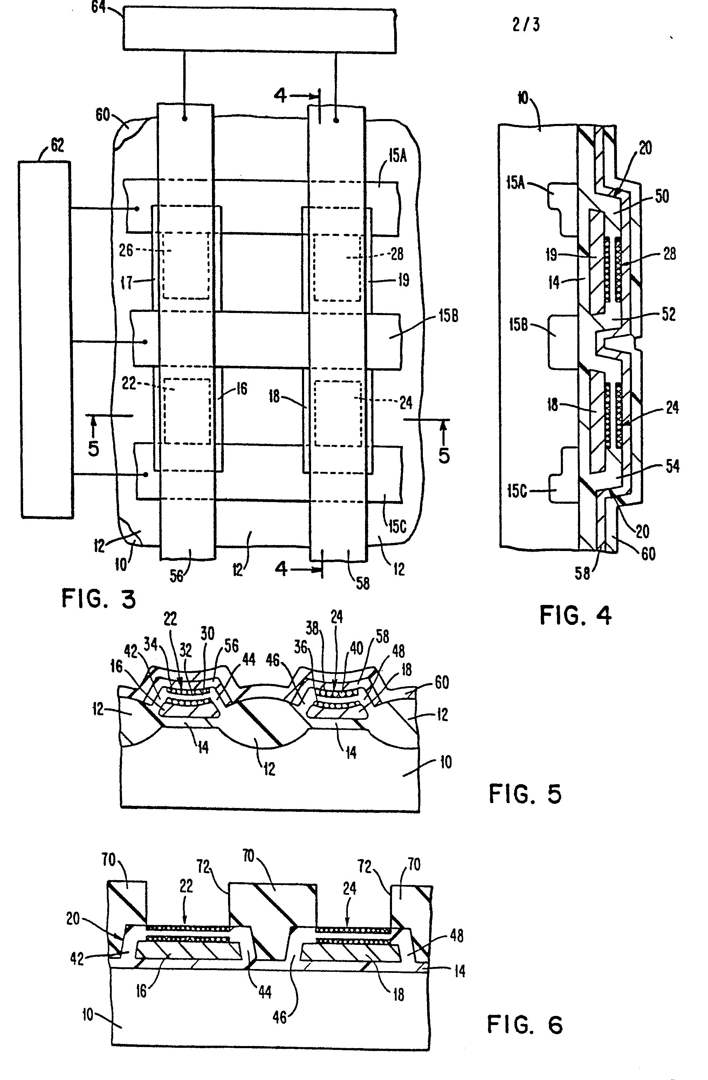

Figs. 3, 4 and 5 of the drawings, a memory system is disclosed which eliminates or minimizes charge leakage between adjacent cells in a memory array, is simple to fabricate and has a very high density of cells. Fig. 3 of the drawing is substantially a plan view of the memory system having an array illustrating four memory cells, with Fig. 4 being a cross-section taken through line 4-4 of Fig. 3 and Fig. 5 being a cross-section of Fig. 3 taken through line 5-5.

As may be seen in Figs. 3, 4 and 5 of the drawings, a semiconductor substrate 10, preferably made of silicon having a P type conductivity has recessed oxides regions 12 formed at the surface thereof with a thin insulating layer 14, preferrably made of silicon dioxide, formed between the recessed oxide regions 12, as shown more clearly in Fig. 5 of the drawings. Lateral extensions of source and drain regions 15A and 15C having an N+ type conductivity, are formed at the surface of the substrate 10 adjacent the thin insulating layer 14, as shown in Fig. 4 by masked ion implantation techniques. Floating gates 16, 17, 18 and 19 are formed over the thin insulating layer 14 by depositing a first layer of doped polysilicon and appropriately using masking and etching techniques, as is well known. After the gate electrodes 16, 17, 18 and 19 are formed, a layer of silicon dioxide 20, or, if desired, another insulation, such as silicon nitride, having a stoichiometric composition is formed over the top and side surfaces of the floating gates 16, 17, 18 and 19, having only localized segments thereof modified to form enhanced conduction insulating layers or segments 22, 24 26 and 28 over and within the edges of the floating gates 16, 18, 17 and 19, respectively, as shown in Fig. 5 of the drawings.

BU 980 021

The enhanced conduction insulating layer 22 includes a lower silicon-rich region 30, a central stoichiometric silicon dioxide region 32 and an upper silicon-rich region 34, with the lower silicon-rich region 30, being adjacent to the floating gate 16, and the enhanced conduction insulating layer 24 includes a lower silicon-rich region 36, a central stoichiometric silicon dioxide region 38 and an upper silicon-rich region 40, with the lower silicon-rich region 36 being adjacent to the floating gate 18. Stoichiometric silicon dioxide regions 42 and 44 of silicon dioxide layer 20 are located adjacent to the sides of the floating gate 16, with the enhanced conduction insulating layer 22 being located only on the top surface of the floating gate 16, and stoichiometric silicon dioxide regions 46 and 48 of silicon dioxide layer 20 are located at the sides of the floating gate 18, with the enhanced conduction insulating layer 24 being limited to the top surface of the floating gate 18, as illustrated in, e.g., Fig. 5 of the drawings. It can also be seen that the sides of the floating gate 19 are covered by stoichiometric silicon dioxide regions 50 and 52, and that floating gate 18 has its edges also protected by the stoichiometric silicon dioxide regions 52 and 54, as indicated in Fig. 4 of the drawings. After the enhanced conduction insulating layers 22, 24, 26 and 28 have been fabricated, first and second conductive lines 56 and 58 are formed parallel to each other and in contact with the enhanced conduction insulating layers or segments 22, 24, 26 and 28, with the first conductive line 56 contacting enhanced conduction insulating layers 22 and 26 and the second conductive line 58 contacting the enhanced conduction insulating layers 24 and 28. The first and second conductive lines 56 and 58 are preferably formed by appropriate masking and etching tech-

BU 980 021

niques from a second layer of doped polysilicon, although, if desired, aluminum lines may be provided. A passivating layer 60, which may be a layer of quartz or silicon dioxide, is then deposited over the entire structure. Appropriate known bit line decoder, driver and sense amplifier circuits 62 are connected to the source and drain regions 15A, 15B and 15C, and appropriate known word line decoder and driver circuits 64 are connected to the first and second conductive lines 56 and 58 to access in any known manner the cells of the array, indicated by the floating gates 22, 24, 26 and 28.

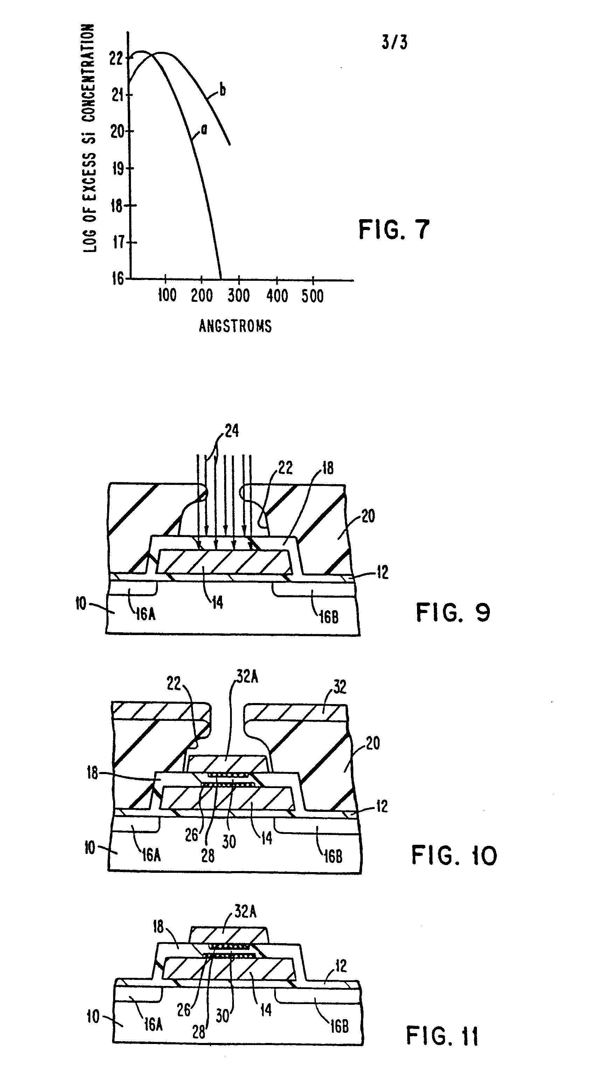

In Fig. 6 of the drawing, there is shown a cross-sectional view similar to that of Fig. 5 but illustrating an intermediate step in the method of making the memory array of the present invention. It can be seen in Fig. 6 that after the stoichiometric silicon dioxide layer 20 has been grown over the floating gates, such as gates 16 and 18, a masking layer 70, which may be a layer of photoresist, is deposited over the entire structure and is provided with openings 72. The openings 72 in the masking layer 70 are made smaller than the upper surface of the floating gates 16 and 18 and are positioned within the edges of the upper surfaces of the floating gates 16 and 18 so as to form each of the enhanced conduction insulating layers 22 and 24, illustrated in Fig. 6, well within the edges of the upper surfaces of the floating gates 16 and 18, respectively.

As is known, the enhanced insulating layer may have a single silicon-rich region, such as region 30 shown in Fig. 5 of the drawings, or it may be made in the form of a dual charge injector having two silicon-rich regions, such as regions 30 and 34 shown in Fig. 5. By using a known ion source, silicon ions may be implanted into the stoichiometric silicon dioxide layer 20 by introducing the ions through the openings 72 in the mask 70 of Fig. 6 with a dose $\emptyset = 1.5 \times 10^{16}/cm^2$ at an energy level E of about 5KeV. Thereby, the top 100Å from the upper surface of layer 20 substantially corresponds to a silicon to oxygen ratio in percent of 40 to 60 and the excess silicon distribution near the upper surface of the stoichiometric silicon dioxide layer 20 takes the form indicated by curve a in Fig. 7 of the drawings to form a silicon-rich region such as region 34. If, a thicker injector or silicon-rich region is required, a $2.0 \times 10^{16}/cm^2$ dose at a 10KeV energy level having the distribution as indicated in Curve b of Fig. 7 may additionally be introduced. The excess silicon concentration produced by the implantation into the silicon dioxide layer 20 serves as a charge injector. The excess silicon concentration decays rapidly into the silicon dioxide layer 20, as indicated in Fig. 7, which indicates the log of excess silicon concentration per cubic centimeter versus depth in angstroms, so that a silicon-rich silicon dioxide portion of the layer 20 is limited to only one side of the layer 20. When an enhanced conduction insulating layer is desired having dual injectors, the structure may be readily made with multiple silicon implantations by employing an ion implant at a given energy level for the upper silicon-rich region and a substantially higher energy ion implant for the lower silicon-rich region to form the dual injector structures as illustrated in Figs. 4, 5 and 6 of the drawings. After implanting the silicon ions into the insulating layer 20, a thermal anneal in an inert gas atmosphere, for example, argon, at 1000°C for 15 minutes is employed to rearrange locally the excess and displaced atoms in a known manner.

It should be noted that the deeper portions of the source and drain regions 15A and 15C and region 15B may be formed by implanting an appropriate N+ impurity, such as arsenic, into the substrate 10 after the floating gates 16, 17, 18 and 19 have been formed using the gates as masks for alignment purposes. It should also be noted that, if desired, a recessed oxide region may be located between the adjacent floating gates 18 and 19 associated with the common or word line 58 shown in Fig. 4 of the drawings. When this recessed oxide region is provided, the N+ region 15B is divided into two segments, with one segment being associated with floating gate 18 and the other segment with floating gate 19.

It should be understood that what is meant herein by a stoichiometric silicon dioxide layer is a chemical composition $SiO_2$ having two atoms of oxygen for each atom of silicon with no significant excess of any reactant or other product.

With the enhanced conduction insulating layer, such as layer 22, having an overall thickness of 450Å, the current-voltage or I-V characteristic was found to be as illustrated in Fig. 8 by curve a, whereas the I-V characteristic for a 450Å thick layer of stoichiometric silicon dioxide is as indicated in Fig. 8 by Curve b. It can be readily seen from Fig. 8, that the electric field required to turn on or to substantially increase the current through the insulating layer is reduced to about one-half by incorporating the silicon-rich regions, for example, 30 and 34, as shown in Fig. 5, into the stoichiometric silicon dioxide layer 20.

BU 980 021

The system illustrated in Figs. 3, 4 and 5 of the drawings and described hereinabove, operates in a known manner, e.g., similar to the operation of the system described in the above-identified Kotecha and Wiedman patent application. To write information into the cell, e.g., to store a one binary digit of information, the floating gate, such as gate 18, of the selected cell is charged to a negative potential by applying a positive voltage of, say, 20 volts to the N+ region 15C while maintaining the conductive or word line 58 at ground or zero potential. When this cell is to be read out by applying an appropriate word pulse to the word line 58, little or no current will flow through the channel region between the N+ regions 15B and 15C. If the floating gate 18 of this selected cell has not been charged to a negative potential, representing a 0 binary digit of information, a higher current would have passed through this channel region. If information is to be rewritten into the selected cell having the charged floating gate, the negative charge on the floating gate 18 is removed by applying a positive voltage of, say, 20 volts to the word line 58 while maintaining the N+ region 15C at ground or zero potential.

In Figs. 9, 10 and 11 of the drawings, cross-sectional views of a cell of the memory array of the present invention are shown at different steps during the making of the array by employing lift-off techniques as an alternative method. The process indicated in Figs. 9, 10 and 11 requires one less mask, which reduces the cost of the array and provides a more dense array, while producing a localized injector or enhanced conduction insulating layer or region. As indicated in Fig. 9, a semiconductor substrate 10 has grown thereon a thin layer of silicon dioxide 12 over which is formed a floating gate 14 by any appropriate masking and etching technique. Source and drain N+ regions 16A and 16B are formed in the semiconductor substrate 10 spaced apart so as to form a channel region therebetween under the floating gate 14, with N+ region 16B being partially overlapped by the floating gate 14. The floating gate 14 is preferably made of doped polysilicon, which may be appropriately oxidized to provide a stoichiometric silicon dioxide layer 18 over the top and side surfaces of the floating gate 14. A lift-off mask 20 having an opening 22 therein is preferably made of a photoresist. Silicon ions 24 are then introduced through the opening 22 of the photoresist mask 20 to form the enhanced conduction insulating layer in the stoichiometric silicon dioxide layer 18 in a manner similar to that described herein above. After the lower and upper silicon-rich regions 26 and 28 are formed with the stoichiometric silicon dioxide region interposed therebetween, an electrode or conductive layer 32, e.g. doped polysilicon is deposited over the photoresist mask 20 with a portion of the conductive metal passing through the opening 22 of the photoresist mask 20 to form an electrode over the silicon-rich regions 26 and 28. After removing the photoresist mask and the unwanted conductive metal deposited on the mask 20, the desired structure is provided having an enhanced conduction insulating layer or segment located on only within the top surface of the floating gate 14 as indicated in Fig. 11 of the drawings. When using the method illustrated in Figs. 9, 10 and 11 of the drawings, a very dense array of memory cells is provided, however, the use of this method does require that the electrodes 32A be connected to a common line. With the embodiment illustrated in Fig. 11 of the drawings, the dual injector insulation structure is contained only

BU 980 021

on the top or upper surface of floating gate 14. Furthermore, contact may be made to electrode 32A without sustaining a contact hole penalty since a continuous metal line or strip, made, e.g., of aluminum, may now be formed directly on the electrode 32A with little or no concern for precise alignment. A further attribute of the structure of Fig. 11 is that it provides a minimum overlap area between the two polysilicon layers 14 and 32A which reduces a known detrimental yield limiting mechanism.

It can be seen that in accordance with the teachings of the present invention, a memory array is provided having fully self-aligned and localized silicon-rich silicon dioxide insulators forming enhanced conduction insulating layers, which is limited in size only by the pitch of the conductive lines formed over and interconnecting the enhanced conduction insulating regions.

While the invention has been particularly shown and described with reference to preferred embodiments, thereof, it will be understood by those skilled in the art, that various changes in form and details may be made therein without departing from the spirit and scope of the invention.

## C L A I M S

1. A memory array including word and bit lines and a plurality of storage cells each having one of a plurality of spaced apart floating gates (16-19), a word line or a control gate (58) coupled to each of said cells, characterized in that an insulating layer (20) is disposed between a surface of each of said floating gates (16-19) and said control gate, said insulating layer (20) including a stoichiometric composition (50, 52) having a given low voltage conduction characteristic disposed between adjacent floating gates from within the edges of the surfaces thereof and a composition (28) disposed between the edges of the surface of each of said floating gates and said control gate having a low voltage conduction characteristic exhibited by higher current flow for low voltages than that of said stoichiometric composition (50, 52).

2. A memory array as set forth in claim 1 comprising a region (28) of enhanced conduction disposed between each of said floating gates and said control gate and within the edges of the surface of said floating gates and a stoichiometric composition region (50, 52) disposed between adjacent floating gates (18 and 19) and extending from within the edge of the surface of one floating gate (19) to within the edge of the surface of an adjacent floating gate (18).

BU 980 021

3. A memory array as set forth in claims 1-2, comprising:

first and second floating gates (18 and 19),

an insulating layer (20) disposed between said control gate and each of said first and second floating gates, said insulating layer (20) including first and second enhanced conduction insulating regions (24, 28) and a region (52) of stoichiometric composition, said first region (24) being disposed between said first floating gate and said control gate and within the edges of said first floating gate (18), said second region (28) being disposed between said second floating gate (19) and said control gate (58) and within the edges of said second floating gate (19), and said stoichiometric composition region (52) being disposed between said first and second floating gates and extending from within the edges of said first floating gate to within the edges of said second floating gate.

4. A memory array as set forth in claim 3 wherein said stoichiometric composition region (52) includes silicon dioxide and said first and second enhanced conduction insulating regions (24, 28) have silicon-rich portions.

5. A memory array as set forth in claim 4, wherein each of said first and second enhanced conduction insulating regions (24, 28) includes first and second spaced apart silicon-rich portions, said first portion being disposed adjacent to said

BU 980 021

control gate and said second portion being disposed adjacent to said floating gates.

6. A memory array as set forth in claim 5 further
including a semiconductor substrate of a first
conductivity type insulated from said first and
second floating gates, said substrate having
spaced apart regions of a second conductivity
type disposed with respect to said floating gates
such that each of said floating gates overlaps a
portion of a respective one of said second conductivity type regions.

7. A memory array as set forth in claim 6, wherein
said semiconductor substrate has a P type conductivity and said spaced apart regions are of
an N+ type conductivity.

8. A memory array as set forth in claims 1 and 2 comprising:

a semiconductor substrate (10) having a first conductivity and a plurality of spaced apart second
type conductivity regions defining current channels,

first and second spaced apart floating gates (18,
18) disposed adjacent said current channels,

a first insulating layer (14) disposed between
said substrate and said first and second floating
gates,

a second insulating layer (20) disposed on the
upper and side surfaces of each of said first and second floating gates, said second insulating layer having first and second enhanced conduction segments and a segment having a stoichiometric composition disposed between said first and second segments, and

a conductive layer disposed on said second insulating layer,

said first enhanced conduction segment being disposed within the edges of the upper surface of said first floating gate and between said first floating gate and said conductive layer, said second enhanced conduction segment being disposed within the edges of the upper surface of said second floating gate and between said second floating gate and said conductive layer and said stoichiometric composition segment being disposed between said conductive layer and said substrate and extending from within the edges of the upper surface of said first floating gate to within the edges of the upper surface of said second floating gate.

9. A memory array as set forth in claim 8, wherein said substrate is made of silicon having a P type conductivity and first and second spaced apart regions are made of N+ type conductivity and are disposed at opposite ends of each of said floating gates, said first and second insulating layers are made of silicon dioxide, and said floating gates and said conductive layer are made of doped polysilicon.

BU 980 021

10. A memory array as set forth in claim 9, wherein each of said enhanced conduction segments includes a silicon-rich region and each of said floating gates overlaps a portion of a respective first N+ region.

11. A memory array as set forth in claim 10, wherein each of said enhanced conduction segments includes first and second spaced apart silicon-rich regions, said first silicon-rich region being disposed adjacent to said conductive layer and said second silicon-rich region being disposed adjacent to a respective floating gate.

12. A memory array as set forth in claim 11, further including means for applying control pulses between said conductive layer and said first N+ regions during a first instance of time for writing information into said floating gates and during a second instance of time for reading information stored in said floating gates.

13. A method of making a memory array as set forth in claims 1-12 comprising the steps of:

forming a first insulating layer (14) on a semiconductor substrate (10) of a given conductivity type,

forming a plurality of spaced apart conductive segments (16-19) on said insulating layer,

forming a second insulating layer (20) over the upper and side surfaces of each of said plurality of conductive segments (16-19) and over said substrate between said conductive segments,

forming a masking layer (70) over said second insulating layer having openings (72) therein disposed over each of said plurality of conductive segments,

introducing ions into said second insulating layer through said openings (72) to form localized enhanced conduction segments (22, 24, 26, 28) over each of said conductive segments and within the edges thereof, and

depositing a conductive film (56 and 58) over each of said localized enhanced conduction segments.

14. A method of making a memory array as set forth in claim 13, wherein said first insulating layer (14) is grown on said substrate and silicon ions are introduced into said second insulating layer (20).

15. A method of making a memory array as set forth in claims 13 and 14, wherein said silicon ions are introduced at first and second energy levels into spaced apart first and second regions, respectively, of said second insulating layer (20) through said openings (72) and wherein each of said openings has a horizontal area significantly smaller than the area of the upper surface of the associated conductive segment.

16. A method of making a memory array as set forth in claim 15, wherein said first region is formed adjacent to said conductive film (56, 58) by said silicon ions at said first energy level and said second region is formed adjacent to said conductive segments by said silicon ions at said second energy level and said second insulating layer (20) is made of silicon dioxide.

17. A method of making a memory array as set forth in claim 13, wherein said conductive film (56, 58) is a continuous film and is etched into a film strip contacting a plurality of said localized enhanced conduction segments and wherein said segments are made of doped polysilicon.

18. A method of making a memory array as set forth in claim 13, wherein said conductive film (56, 58) is evaporated over each of said localized enhanced conduction segments through said openings.

FIG. 1 (PRIOR ART)

FIG. 2 (PRIOR ART)

FIG. 8

FIG. 3

FIG. 4

FIG. 5

FIG. 6

FIG. 7

FIG. 9

FIG. 10

FIG. 11